# FASCICULE DE BREVET EUROPEEN

(11) **EP 3 758 175 B1**
(45) Date de publication et mention de la délivrance du brevet: **07.06.2023**
(21) Numéro de dépôt: 20181550.3
(22) Date de dépôt: 23.06.2020
(51) Int. Cl.: H02B 1/044, H02B 1/56, H05K 7/20, H02B 1/30, H02B 1/38

(54) **ARMOIRE ÉLECTRIQUE AVEC BLOC DE CONDITIONNEMENT D'AIR**
SCHALTSCHRANK MIT KLIMAANLAGENBLOCK
ELECTRICAL CABINET WITH AIR-CONDITIONING UNIT

(30) Priorité: 24.06.2019 FR 1906781
(43) Date de publication de la demande: 30.12.2020
(73) Titulaire: Schneider Electric Industries SAS, 92500 Rueil Malmaison (FR)
(72) Inventeur: GUINEBERT, Patrick, 38050 GRENOBLE Cedex 09 (FR)
(74) Mandataire: Lavoix

(56) Documents cités:
- WO-A1-03/037055
- DE-U1- 20 104 847
- DE-U1- 20 318 650
- US-A- 4 949 867

## Description

La présente invention concerne une armoire électrique qui comprend un bâti et une porte articulée sur ce bâti, équipée d'un bloc de conditionnement d'air.

Au sens de la présente invention, une armoire électrique est une armoire destinée à contenir des appareils électriques pour la répartition de courant ou le contrôle d'une machine. Ces appareils électriques peuvent comprendre des répartiteurs de courant, des disjoncteurs, des automates, ainsi que d'autres matériels.

US 4 949 867 A divulgue un panneau de contrôle comprenant un bâti, ainsi qu'une paroi de montage. Un dispositif de conditionnement d'air est inséré dans un orifice de la paroi de montage.

DE 203 18 650 décrit un dispositif de montage pour monter un bloc de climatisation dans un orifice d'une armoire électrique. Ce dispositif de montage est destiné à être placé sous le bloc de climatisation.

DE 201 04 847 U1 décrit une armoire électrique comprenant un premier module muni d'un bloc de climatisation monté dans un orifice d'un second module, les deux modules étant maintenus ensemble par des éléments de montage.

Il est connu de fabriquer des armoires électriques munies d'un bloc de conditionnement d'air monté à l'aide de vis vissées sur le bloc de conditionnement d'air et sur la face intérieure d'une porte de l'armoire électrique. Ce montage ne peut avoir lieu qu'avec la porte ouverte, celle-ci étant en porte-à-faux au-delà de ses charnières par rapport au bâti de l'armoire. Dans cette configuration, la porte est fortement sollicitée, ce qui peut nuire au fonctionnement ultérieur des charnières ou induire des déformations plastiques de la porte.

En outre, ces manipulations sont longues et compliquées et requièrent une main d'oeuvre qualifiée.

C'est à ces inconvénients qu'entend plus particulièrement remédier cette invention en proposant une nouvelle armoire électrique plus facile et plus rapide à assembler, le bloc de conditionnement d'air pouvant être monté avec la porte en position fermée.

A cet effet, l'invention concerne une armoire électrique comprenant un bâti et une porte articulée sur ce bâti et équipée d'un bloc de conditionnement d'air reçu dans une ouverture ménagée à travers la porte. Selon l'invention, un support est fixé de chaque côté de l'ouverture, sur la face intérieure de la porte, alors que chaque support est équipé d'au moins un logement de réception et de blocage par gravité d'une tige d'un pion porté par le bloc de conditionnement d'air. Chaque support est configuré pour que le pion puisse être engagé dans le logement de réception et de blocage par gravité en insérant le bloc de conditionnement d'air dans l'ouverture de la porte, à partir de la face extérieure de la porte. En outre, au moins un organe mécanique monté sur la face intérieure de la porte permet de verrouiller chaque pion en configuration bloquée dans son logement.

Grâce à l'invention, les supports montés sur la face intérieure de la porte permettent le montage du bloc de conditionnement d'air alors que la porte est en position fermée. Le ou les logements de chaque support permettent de bloquer le bloc de conditionnement d'air sans l'intervention de l'opérateur du côté intérieur de la porte. En outre, l'organe mécanique fiabilise le blocage du bloc de conditionnement d'air par rapport à la porte. Comme il est monté sur la face intérieure de la porte, il n'est pas accessible lorsque la porte est en position fermée, ce qui évite tout démontage frauduleux du bloc de conditionnement d'air. Le montage du bloc de conditionnement d'air sur l'armoire est facile et rapide. Il peut être accompli par un seul opérateur. Si un joint d'étanchéité est prévu à l'interface entre le bloc de conditionnement d'air et la porte, l'invention permet une compression homogène de ce joint autour de l'ouverture.

Selon des aspects avantageux mais non obligatoires de l'invention, une telle armoire peut incorporer une ou plusieurs des caractéristiques suivantes, prises selon toute combinaison techniquement admissible :
- Chaque logement comprend un siège, destiné à bloquer un pion par gravité, et une partie de guidage du pion vers ce siège.
- Le support est un profilé à section en L dans lequel chaque logement est formé par une découpe ménagée dans les deux branches du L.
- La découpe comprend, d'une part, une embouchure ménagée sur une première des deux branches du L et, d'autre part, la partie de guidage et le siège ménagés sur la deuxième branche du L, alors que la partie de guidage relie l'embouchure et le siège.
- Le bloc de conditionnement d'air est équipé d'un cadre pourvu d'un joint d'étanchéité en appui sur la face extérieure de la porte autour de l'ouverture.
- Le bloc de conditionnement d'air porte quatre pions répartis deux par deux sur chacun de ses côtés et chaque support est équipé de deux logements de réception et de blocage par gravité d'une partie d'un pion.
- L'organe mécanique est une vis vissée dans une partie d'un support et dont une extrémité est en appui sur le bloc de conditionnement d'air.
- En variante, l'organe mécanique est un verrou quart de tour.
- Chaque pion est muni d'une tête de verrouillage dans le logement selon un axe parallèle à l'axe longitudinal du pion.

Selon un autre aspect, l'invention concerne également une méthode d'assemblage d'une armoire électrique telle que définie ci-dessus. Cette méthode comprend au moins des étapes consistant à
a) découper l'ouverture dans la porte ;
b) monter un support de chaque côté de l'ouverture de la face intérieure de la porte ;
c) fermer la porte ;
d) insérer le bloc de conditionnement d'air dans l'ouverture de la porte, à partir de sa face extérieure, en engageant chaque pion dans un logement d'un des deux supports ;
e) laisser chaque pion glisser, par gravité, vers une position de blocage dans le logement ;
f) ouvrir la porte ;
g) actionner l'organe mécanique pour verrouiller chaque pion dans sa position de blocage dans son logement.

L'invention sera mieux comprise et d'autres avantages de celle-ci apparaitront plus clairement à la lumière de la description qui va suivre d'un mode de réalisation d'une armoire électrique et de sa méthode d'assemblage conformes à son principe, donnée uniquement à titre d'exemple et faite en référence aux dessins annexés, dans lesquels :
[Fig 1] la figure 1 est une vue en perspective d'une armoire électrique conforme à l'invention ;

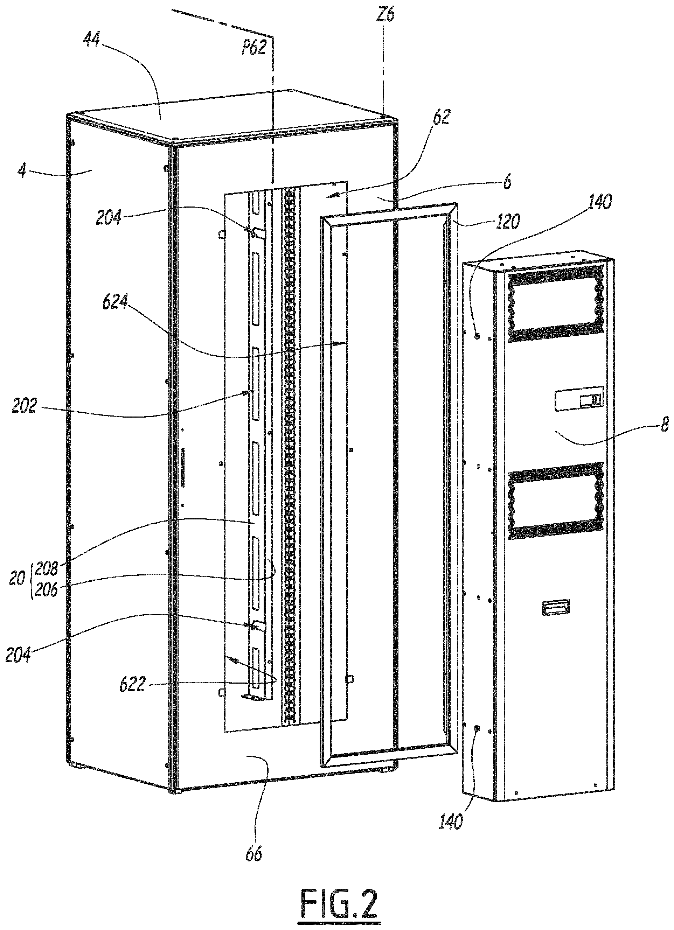

[Fig 2] la figure 2 est une vue en perspective éclatée de l'armoire de la figure 1 ;

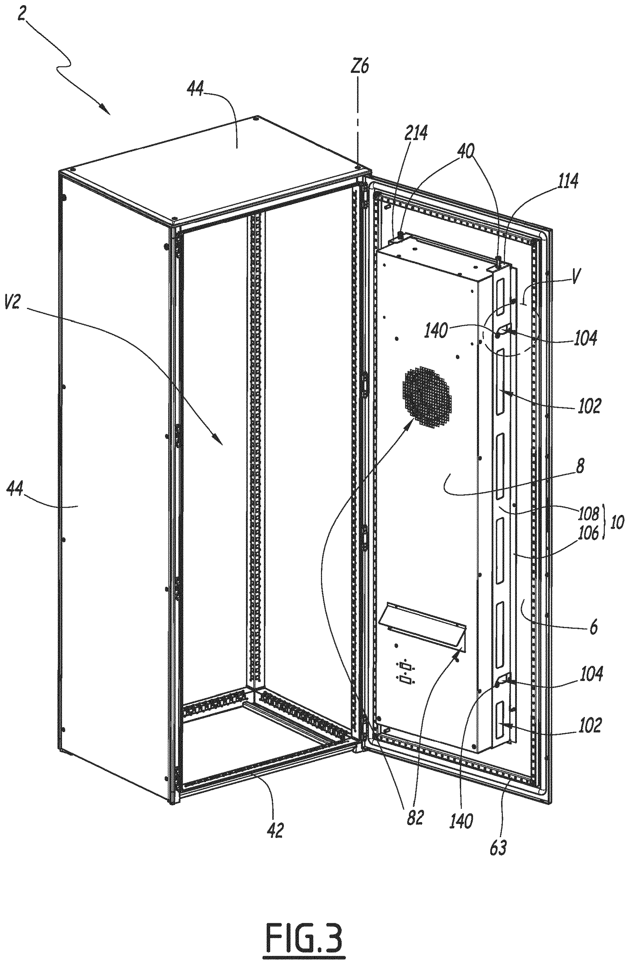

[Fig 3] la figure 3 est une vue en perspective de l'armoire des figures 1 et 2 avec sa porte ouverte ;

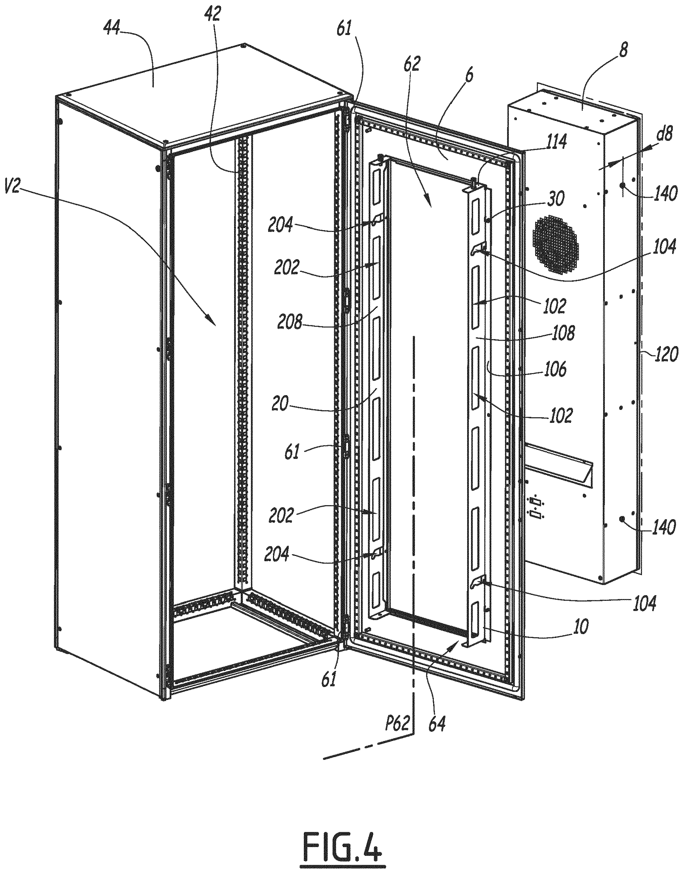

[Fig 4] la figure 4 est une vue en perspective éclatée de l'armoire des figures 1 à 3 dans la configuration de la figure 3 ;

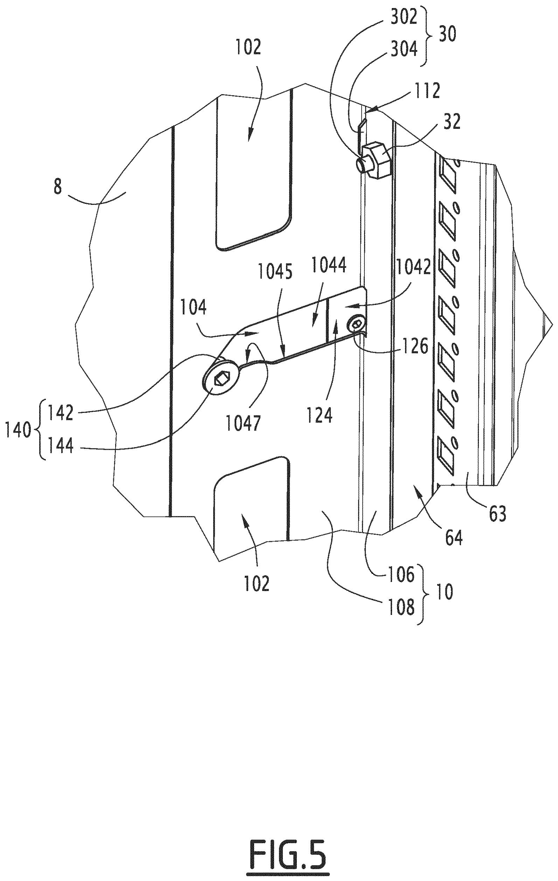

[Fig 5] la figure 5 est une vue à plus grande échelle du détail V à la figure 3 ;

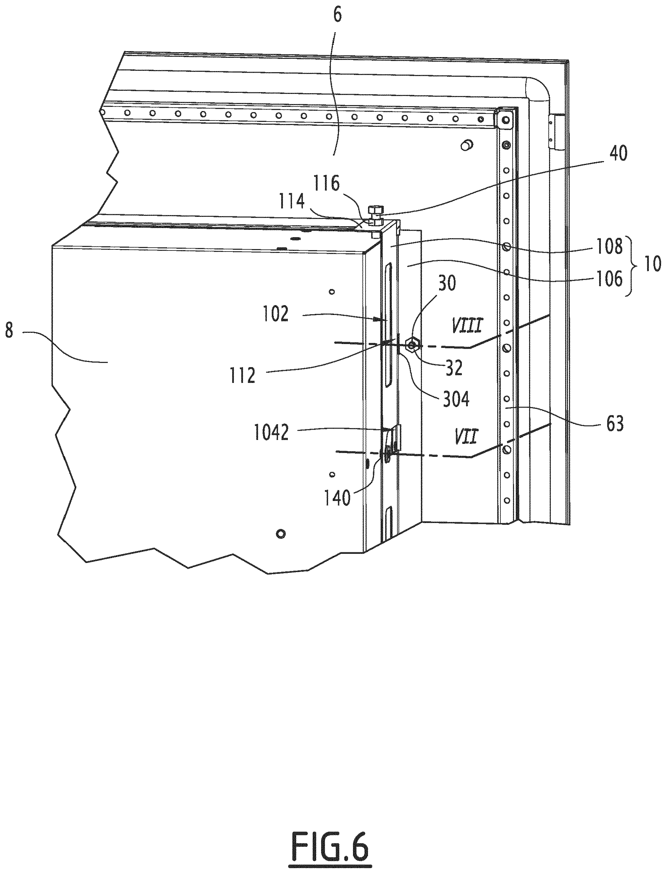

[Fig 6] la figure 6 est une vue en perspective partielle de l'armoire vue par le côté intérieur de la porte ;
[Fig 7] la figure 7 est une coupe selon le plan VII à la figure 6 ;
[Fig 8] la figure 8 est une coupe selon le plan VIII à la figure 6 ;
[Fig 9] la figure 9 est une vue en perspective de l'armoire des figures précédentes en cours d'assemblage ;
[Fig 10] la figure 10 est une coupe partielle d'un support et d'un pion de l'armoire des figures précédentes lors d'une étape d'assemblage postérieure à celle de la figure 9 ; et
[Fig 11] la figure 11 est une coupe analogue à celle de la figure 10 lors d'une étape d'assemblage postérieure à celle de la figure 10.

L'armoire 2 représentée sur les figures comprend un bâti fixe 4 et une porte 6 articulée sur le bâti fixe 4 autour d'un axe Z6, qui est vertical lorsque l'armoire 2 repose sur un sol plan, au moyen de charnières 61. Le bâti fixe 4 comprend une armature 42 et des panneaux 44. Seuls deux de ces panneaux, à savoir ceux formant le plafond et le côté gauche de l'armoire, sont visibles sur les figures.

La porte 6 est percée d'une ouverture 62. Un bloc de conditionnement d'air 8 est monté dans cette ouverture 62. Le bloc de conditionnement d'air 8 peut être aussi appelé bloc de climatisation.

Le bloc de conditionnement d'air 8 comprend un ou plusieurs orifices d'aspiration/de refoulement 82 orientés vers le volume intérieur V2 de l'armoire 2, ainsi qu'un ou plusieurs orifices d'aspiration/de refoulement 84 orientés vers l'extérieur de l'armoire 2. Le bloc de conditionnement d'air 8 comprend également un panneau de commande 86 situé sur la face du bloc de conditionnement d'air 8 orientée vers l'extérieur de l'armoire 2.

On note 622 et 624 les bords longitudinaux de l'ouverture 62, c'est-à-dire les bords verticaux de l'ouverture 62 lorsque l'armoire 2 repose sur un sol plan. On note 64 la face intérieure de la porte 6 qui est orientée vers le volume intérieur V2 de l'armoire 2 lorsque la porte est fermée et 66 la face extérieure de la porte 6 qui est opposée à la face intérieure 64 et orientée vers l'extérieur de l'armoire 2.

Sur sa face intérieure 64, la porte 6 est équipée d'un cadre de rigidification 63 qui s'étend parallèlement au bords longitudinaux et transversaux de la porte 6.

Deux supports 10 et 20 sont montés sur la face intérieure 64 de la porte 6, respectivement le long des bords longitudinaux 622 et 624. On note P62 un plan médian de l'ouverture 62 qui est parallèle à ces bords longitudinaux 622 et 624 et à égale distance de ceux-ci. Les supports 10 et 20 sont symétriques par rapport au plan P62.

On décrit ci-après plus particulièrement le support 10, la description du support 20 pouvant être déduite par symétrie. Le support 10 est un profilé métallique à section en L, il comprend des ouvertures d'allégement 102. Le support 10 est également muni de deux découpes 104. En section transversale, le support 10 est formé d'une première branche 106 plaquée contre la face intérieure 62 de la porte 6 et d'une deuxième branche 108 perpendiculaire à la première branche 106 et qui s'éloigne de la face intérieure 62 de la porte 6. Les ouvertures d'allégement 102 sont ménagées sur la deuxième branche 108.

Chaque découpe 104 est composée d'une embouchure 1042, d'une partie de guidage 1044 et d'un siège 1046. L'embouchure 1042 est ménagée dans la première branche 106 et dans l'angle de jonction entre les deux branches 106 et 108. La partie de guidage 1044 prolonge l'embouchure 1042 dans la deuxième branche 108. Le siège 1046 prolonge la partie de guidage 1044 à l'opposé de l'embouchure 1042. Ainsi, la partie de guidage 1044 relie l'embouchure 1042 et le siège 1046.

Le siège 1046 est borgne, c'est-à-dire qu'il ne débouche pas du côté opposé à l'embouchure 1042. Le siège 1046 prolonge la partie de guidage 1044 vers le bas, à l'opposé de l'embouchure 1042. En d'autres termes, le bord du siège 1046 est situé plus bas que le bord inférieur 1045 de la partie guidage du bord 1044.

A partir de l'embouchure 1042, le bord inférieur 1045 est plan et horizontal lorsque l'axe Z6 est vertical. En se rapprochant du siège 1046, le bord 1045 forme une bosse 1047 en saillie vers le haut par rapport à sa partie plane.

Le support 10 est fixé sur la porte 6 au moyen de deux brides 30 qui comprennent chacune un goujon fileté 302 serti dans une tôle 303 qui comprend une patte d'encrage temporaire 304. Pour monter le support 10 sur la porte 6, on commence par engager le goujon 302 de chaque bride de fixation 30 dans un perçage 68 ménagé à cet effet dans la porte 6 au voisinage du bord 622, avec la patte d'encrage 304 qui vient en recouvrement localisé du bord 622. Le support 10 est muni de deux perçages 110 et de deux entailles 112, prévus pour recevoir respectivement le goujon 302 et la patte d'encrage 304 d'une bride de fixation 30. Les entailles 112 sont ménagées dans la zone de jonction entre les deux branches 106 et 108. Lorsque les brides de fixation 30 sont en place dans la porte 6, on peut suspendre le support 10 en engageant les trous 110 et les entailles 112 autour des goujons 302 et des pattes d'encrage 304. Le support 10 est ainsi retenu temporairement sur la porte 6 et peut être immobilisé de façon pérenne sur celle-ci en vissant un écrou 32 sur chaque goujon 302.

Dans cette configuration immobilisée du support 10 sur la porte 6, les deux embouchures 1042 sont en regard de l'ouverture 62 de la porte 6 au voisinage du bord 622.

La deuxième branche 108 est munie d'un retour 114 perpendiculaire aux branches 106 et 108 et dirigé vers l'autre support 20. Ainsi, le retour 114 est au-dessus du bord supérieur de l'ouverture 62. Le retour 114 est percé d'un orifice et un écrou 116 est soudé sur le retour 114, en regard de cet orifice. Une vis de verrouillage 40 traverse l'orifice en étant vissée dans l'écrou 116.

De façon comparable au support 10, le support 20 est muni d'ouvertures d'allégement 202, de découpes 204 de géométrie comparables aux découpes 104, d'une première branche 206, d'une deuxième branche 208 et d'un retour 214 muni d'un écrou et d'une vis de verrouillage 40.

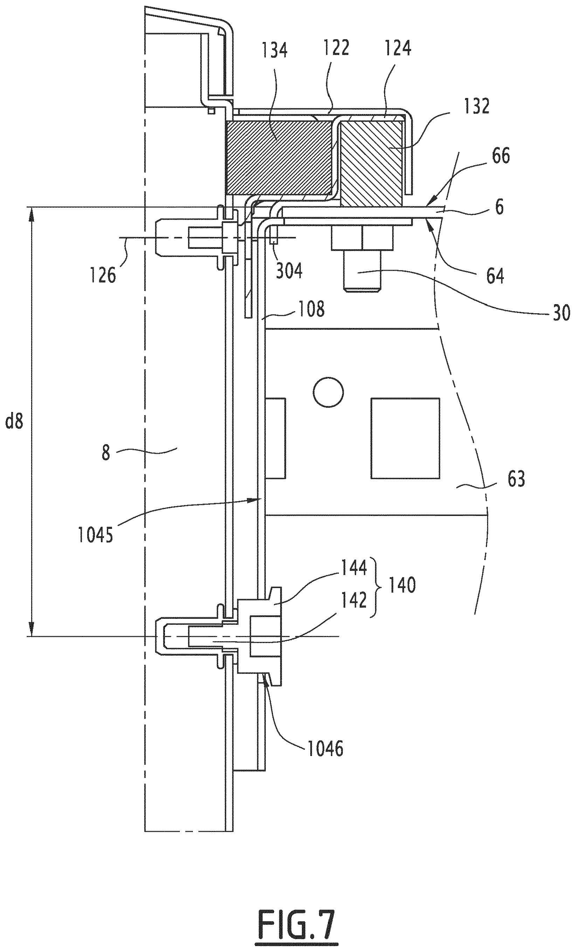

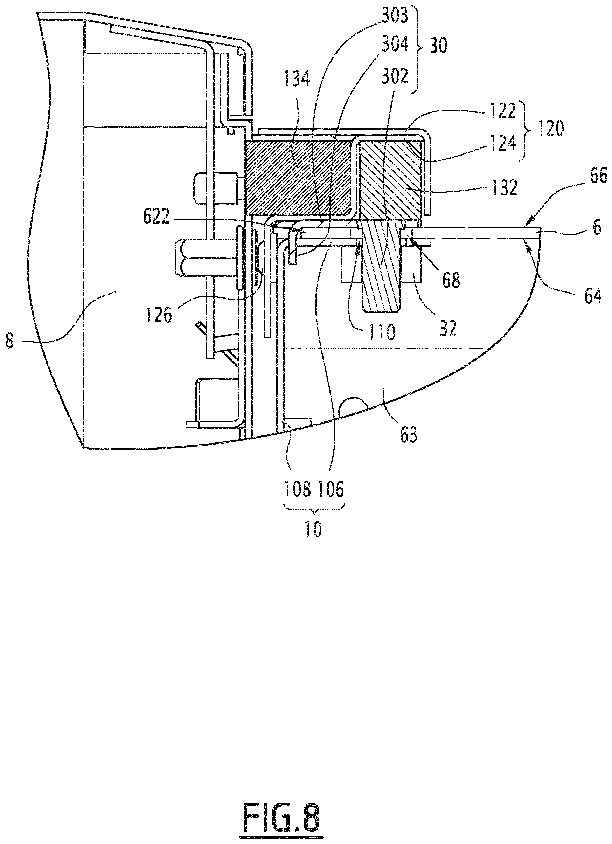

Le bloc de conditionnement d'air 8 est équipé d'un cadre périphérique 120 qui longe les surfaces latérales gauche, droite, supérieure et inférieure du bloc de conditionnement d'air 8. Comme visible aux figures 7 et 8, le cadre 120 est composé d'un premier profilé extérieur 122 et d'un deuxième profilé intérieur 124. Le cadre 120 est immobilisé autour du bloc de conditionnement d'air 8 au moyen de vis 126 qui traversent le cadre, sont réparties sur la largeur et la hauteur de celui-ci et sont vissés dans le bloc de conditionnement d'air 8.

On note H8 la hauteur du bloc de conditionnement d'air 8, qui est légèrement inférieure à la distance entre les bords supérieur et inférieur de l'ouverture 62, ℓ8 la largeur du bloc de conditionnement d'air 8, qui est légèrement inférieure à la distance entre les bords 622 et 624 de l'ouverture 62 et P8 la profondeur du bloc de conditionnement d'air 8, qui est perpendiculaire à sa hauteur et à sa largeur. La position du cadre 120 selon la profondeur P8 du bloc de conditionnement d'air 8 est définie par la position des vis 126 d'immobilisation du cadre 120 sur ce bloc. Cette position peut être choisie par le concepteur de l'armoire 2 en fonction du degré d'enfoncement souhaité pour le bloc de conditionnement d'air 8 dans le volume intérieur V2.

Le cadre 120 porte deux joints 132 et 134. Le premier joint 132 travaille en compression entre le cadre 120 et la porte 6 selon un axe parallèle à la profondeur du bloc de conditionnement d'air 8. Le deuxième joint 134 travaille en compression entre le cadre 120 et le bloc de conditionnement d'air 8 selon l'axe parallèle à la largeur du bloc de conditionnement d'air 8. Lorsque le cadre 120 est monté sur le bloc de conditionnement d'air 8, le joint 134 est comprimé.

Sur chacun de ses côtés, le bloc de conditionnement d'air 8 porte deux pions 140 destinés à être engagés dans les découpes 104 et 204. Chaque pion 140 est composé d'une tige 142 et d'une tête 144. Dans l'exemple des figures, la tige 142 est filetée. Ainsi, chaque pion 140 est une vis.

On considère maintenant les pions 140 situés sur le côté du bloc de conditionnement d'air 8 le plus proche du bord longitudinal 622 de l'ouverture 62. La tige 142 de chacun de ces pions 140 est destinée à traverser l'embouchure 1042 d'une découpe 104 pour pénétrer dans sa partie de guidage 1044 et être poussée vers le siège 1046 en glissant sur le bord inférieur 1045 de la partie de guidage 1044. Lors du déplacement d'un pion 140 au sein d'une ouverture 104, sa tête 144 recouvre partiellement le bord 1045 puis le bord du siège 1046. Le bloc de conditionnement d'air 8 est ainsi verrouillé selon sa largeur ℓ8, c'est-à-dire parallèlement à l'axe du pion 140, entre les supports 10 et 20.

On note d8 la distance, mesurée parallèlement à la profondeur P8 du bloc de conditionnement d'air 8, entre l'axe d'un pion 140 et la surface du joint 132 opposée au cadre 120. On note d104 la distance entre l'embouchure 1042 d'une découpe 104 et un axe vertical passant par le centre du siège 1046 de cette découpe, cette distance étant mesurée parallèlement à la deuxième branche 108 et perpendiculairement à la première branche 106 du support 10. Compte tenu de l'épaisseur de la porte 6, la distance d8 est légèrement supérieure à la distance d104. Le rapport d8/d104 est choisi de telle sorte que, lorsque les pions 140 sont reçus et bloqués dans les sièges 1046, le joint 132 est comprimé par le cadre 120 contre la face extérieure 66 de la porte 6.

L'assemblage de l'armoire 2 a lieu de la façon suivante :
Tout d'abord, le bâti fixe 4 est constitué en montant les panneaux 44 sur l'armature 42 et l'ouverture 62 est découpée dans la porte 6.

Ensuite, les supports 10 et 20 sont montés de chaque côté de l'ouverture 62 le long des bords 622 et 624 sur la face intérieure 64 de la porte 6. Ce montage a lieu en utilisant les brides 30 et les écrous 32 comme expliqué ci-dessus.

Puis la porte est articulée sur le bâti fixe 4, au moyen des charnières 61. La porte 6 est ensuite fermée.

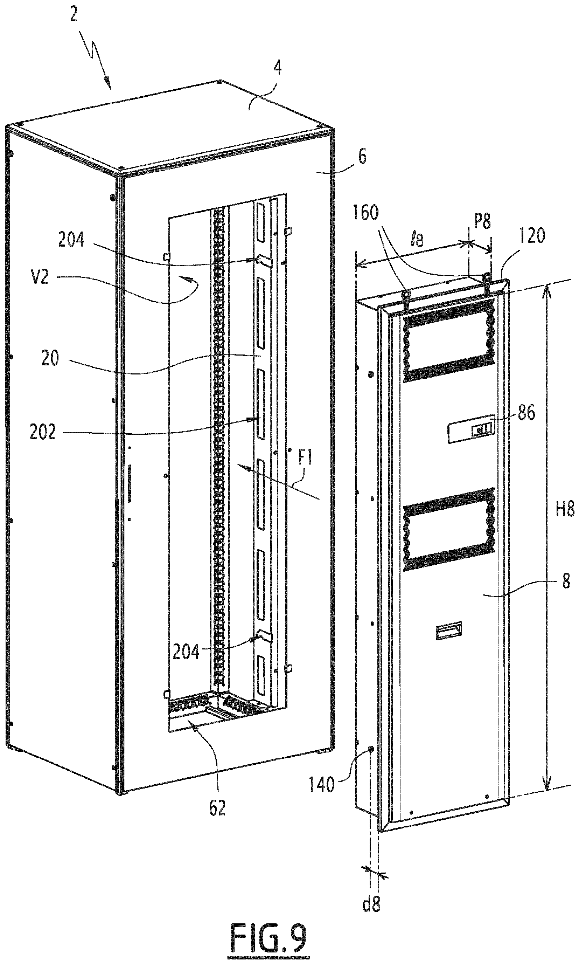

Avant ou après les étapes mentionnées ci-dessus, le bloc de conditionnement d'air 8 est équipé d'un cadre 120, de quatre pions 140 et de deux crochets de supportage 160 qui ne sont représentés qu'à la figure 9.

Le bloc de conditionnement d'air 8 est ensuite soulevé au moyen d'élingues accrochées aux crochets 160, puis inséré dans la découpe 62, depuis l'extérieur de la porte 6, en le poussant vers le volume V2, dans le sens de la flèche F1 à la figure 9.

Ce mouvement est possible grâce à l'engagement des pions 140 dans les embouchures respectives des découpes 104 et 204. On note que cette opération peut être effectuée par un seul opérateur situé à l'extérieur de l'armoire 2.

L'opérateur peut alors relâcher le bloc de conditionnement d'air 8 et les pions 140 viennent en appui sur les bords inférieurs 1045 et équivalents des découpes 104 et 204 sous l'effet de la gravité qui s'applique sur le bloc de conditionnement d'air 8 lorsque les élingues sont détachées des crochets 160. L'opérateur peut ensuite pousser le bloc de conditionnement d'air 8 vers l'intérieur du volume V2 de l'armoire 2, ce bloc 8 étant guidé vers les sièges 1046 et équivalents par les bords inférieurs 1045 et équivalents des parties de guidage 1044 et équivalentes.

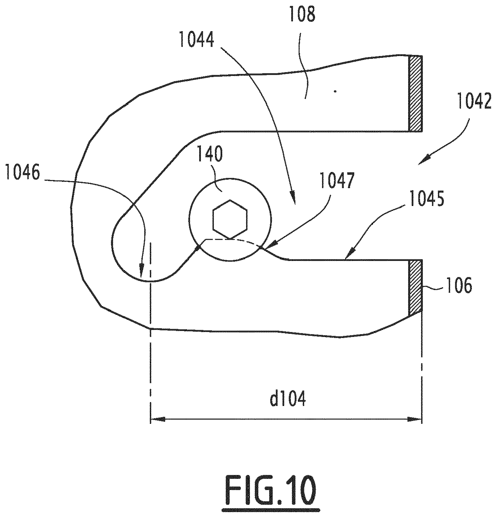

En s'éloignant de l'embouchure, dans une partie de guidage d'une découpe 104 ou 204, chaque pion 140 entre en contact avec une bosse 1047 qu'il franchit sous l'effort de poussée exercé par l'opérateur dans le sens de la flèche F1, comme représenté à la figure 10. Ainsi, chaque bosse 1047 constitue un point dur lors du déplacement d'un pion 140 entre l'embouchure et le siège d'une découpe 104 ou 204. Ce point dur est sensible par l'opérateur, qui détecte ainsi facilement quand les pions 140 parviennent dans les sièges.

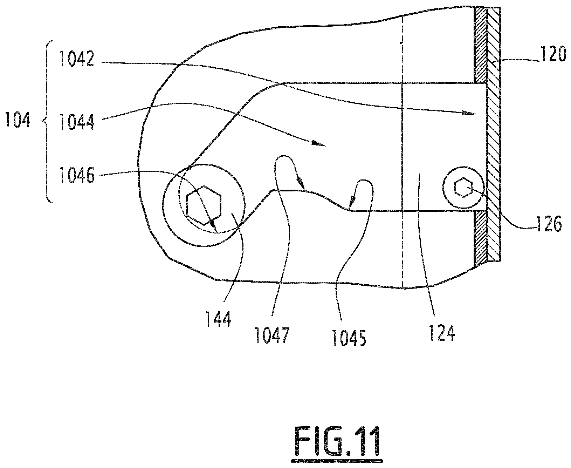

En arrivant dans les sièges 1046 et équivalents, les pions 140 sont guidés par gravité vers le fond de ces sièges où ils se bloquent compte tenu de la géométrie des découpes 104 et 204, comme représenté à la figure 11. Ainsi, les découpes 104 et 204 constituent chacune un logement de réception temporaire de la tige 142 d'un pion 140 dans une partie de guidage 1044 ou équivalente et de blocage de cette tige par gravité dans un siège 1046 ou équivalent.

Par convention, les figures 10 et 11 ne montrent que ce qui est visible à travers la découpe 104 et pas ce qui est situé à l'extérieur de celle-ci, comme le profilé intérieur 124 ou la vis 126 qui ne sont pas visibles, au sein de la découpe 104, dans la configuration de la figure 10 car ils n'ont pas encore atteint l'embouchure 1042.

Au cours de la progression des pions 140 dans les découpes 104 et 204 et compte tenu du rapport d8/d104, le joint 132 est amené en contact et en compression contre la face extérieure 66 de la porte 6. Il constitue donc une barrière d'étanchéité autour de l'ouverture 62 de la porte 6 et du bloc de conditionnement d'air 8.

Au terme des étapes précitées, le bloc de conditionnement d'air 8 est en place au sein de l'ouverture 62 de la porte 6, où il est maintenu par gravité. L'opérateur peut alors ouvrir la porte 6 sans risque de déstabiliser le bloc de conditionnement d'air 8. Ceci lui permet d'accéder aux deux vis de verrouillage 40 et de les serrer dans les écrous 116 pour maintenir le bloc de conditionnement d'air 8 en position et verrouiller les tiges 142 des pions 140 dans les sièges 1046 et équivalents des découpes 104 et 204.

Une fois la porte 6 refermée, les vis 40 ne sont plus accessibles, ce qui évite un démontage frauduleux du bloc de conditionnement d'air 8.

Ainsi, l'invention permet un montage facile et rapide du bloc de conditionnement d'air 8 sur la porte 6 par un seul opérateur sans risquer d'endommager la porte 6 ou les charnières 61. Le montage peut se faire en aveugle, c'est-à-dire sans que l'opérateur ait besoin de voir l'intérieur du volume V2 de l'armoire 2. Grâce à l'invention, le joint 132 peut être comprimé de façon homogène autour de l'ouverture 62. Il peut s'agir d'un joint standard du commerce dont le coût est bien maîtrisé. Les deux supports 10 et 20 participent à la rigidification de la porte 6, en complément, voire à la place, du cadre 63. L'invention permet de maintenir une étanchéité conforme au standard IP55, y compris lorsque les matériels compris dans l'armoire 2 ou le bloc de conditionnement d'air 8 vibrent. En effet, les vis de verrouillage 40 assurent un verrouillage du bloc de conditionnement d'air 8 en place dans l'ouverture 62.

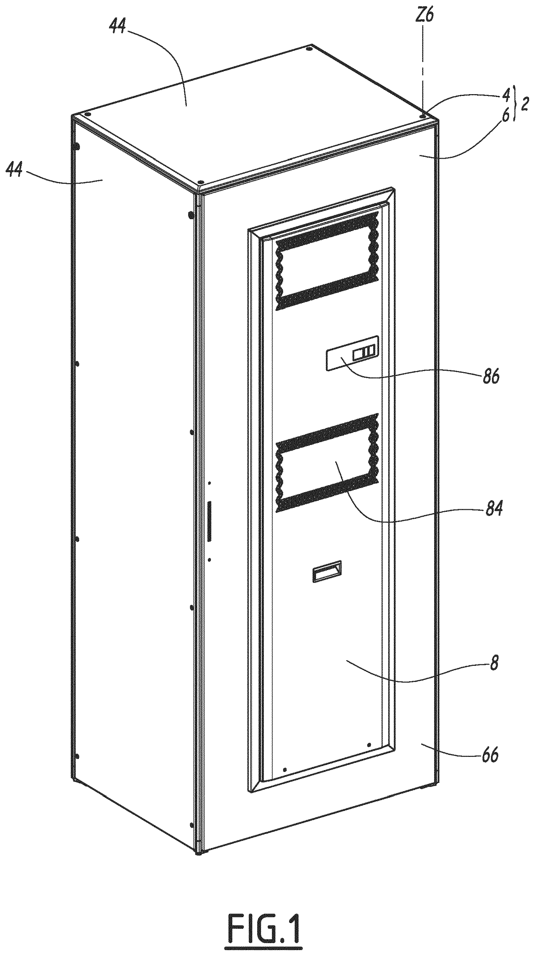

En fonction du positionnement des pions 140 et du cadre 120 selon la profondeur P8 du bloc de conditionnement d'air 8, celui-ci peut être plus ou moins en saillie par rapport à la face extérieure 66 de la porte 6. Si l'on dispose d'assez de place à l'intérieur de l'armoire 2, le bloc de conditionnement d'air 8 peut être monté pratiquement affleurant à la face extérieure 66 de la porte 6 comme représenté aux figures 1, 7 et 8. En variante, le bloc de conditionnement d'air 8 peut être en saillie vers l'extérieur de la porte 6 sur une partie substantielle de sa profondeur, par exemple un quart ou un tiers de sa profondeur P8.

L'invention est représentée sur les figures dans le cas où les supports 10 et 20 comportent deux découpes 104 et 204 et le bloc de conditionnement d'air 8 porte quatre pions 140. L'invention est applicable pour autant que chacun des supports 10 et 20 comprend au moins une découpe, le nombre de pions 140 sur chacun des côtés du bloc de conditionnement d'air 8 étant alors adapté.

En variante, à la place des vis de verrouillage 40, on peut utiliser un ou des verrous quart-de-tour pour immobiliser les pions 140 dans les sièges 1046 et équivalents des découpes 104 et 204.

Selon une autre variante, les pions 140 sont constitués par des rivets ou des doigts métalliques immobilisés sur le bloc de conditionnement d'air 8.

## Revendications

1. Armoire électrique (2) comprenant un bâti (4) et une porte (6) articulée sur ce bâti et équipée d'un bloc de conditionnement d'air (8) reçu dans une ouverture (62) ménagée à travers la porte, **caractérisée en ce qu'**un support (10, 20) est fixé de chaque côté de l'ouverture, sur la face intérieure (64) de la porte, **en ce que** chaque support est équipé d'au moins un logement (104, 204) de réception et de blocage par gravité d'une partie (142) d'un pion (140) porté par le bloc de conditionnement d'air, **en ce que** chaque support est configuré pour que le pion puisse être engagé dans le logement de réception et de blocage par gravité en insérant le bloc de conditionnement d'air dans l'ouverture de la porte, à partir de la face extérieure (66) de la porte, et **en ce qu'**au moins un organe mécanique (40) monté sur la face intérieure de la porte permet de verrouiller chaque pion en configuration bloquée dans son logement.

2. Armoire électrique (2) selon la revendication 1, **caractérisée en ce que** chaque logement (104, 204) comprend un siège (1046), destiné à bloquer un pion par gravité, et une partie de guidage (1044) du pion vers ce siège.

3. Armoire électrique (2) selon l'une des revendications précédentes, **caractérisée en ce que** le support (10, 20) est un profilé à section en L dans lequel chaque logement est formé par une découpe (104, 204) ménagée dans les deux branches (106, 108, 206, 208) du L.

4. Armoire électrique (2) selon les revendications 2 et 3, **caractérisée en ce que** la découpe (104, 204) comprend, d'une part, une embouchure (1042) ménagée sur une première des deux branches du L (106, 206) et, d'autre part, la partie de guidage (1044) et le siège (1046) ménagés sur la deuxième branche du L (108, 208) et **en ce que** la partie de guidage relie l'embouchure et le siège.

5. Armoire électrique (2) selon l'une des revendications précédentes, **caractérisée en ce que** le bloc de conditionnement d'air (8) est équipé d'un cadre (120) pourvu d'un joint d'étanchéité (132) en appui sur la face extérieure (66) de la porte (6) autour de l'ouverture (62).

6. Armoire électrique (2) selon l'une des revendications précédentes, **caractérisée en ce que** le bloc de conditionnement d'air (8) porte quatre pions (140) répartis deux par deux sur chacun de ses côtés et **en ce que** chaque support (10, 20) est équipé de deux logements (104, 204) de réception et de blocage par gravité d'une partie d'un pion.

7. Armoire électrique (2) selon l'une des revendications précédentes, **caractérisée en ce que** l'organe mécanique (40) est une vis vissée dans une partie (114, 214) d'un support (10, 20) et dont une extrémité est en appui sur le bloc de conditionnement d'air (8).

8. Armoire électrique (2) selon l'une des revendications 1 à 6, **caractérisée en ce que** l'organe mécanique (40) est un verrou quart de tour.

9. Armoire électrique (2) selon l'une des revendications précédentes, **caractérisée en ce que** chaque pion (140) est muni d'une tête (144) de verrouillage dans son logement (104, 204) selon un axe parallèle à l'axe longitudinal du pion.

10. Méthode d'assemblage d'une armoire électrique (2) selon l'une des revendications précédentes, la méthode comprenant au moins des étapes consistant à :
a) découper l'ouverture (62) dans la porte (6) ;
b) monter un support (10, 20) de chaque côté de l'ouverture sur la face intérieure (64) de la porte ;
c) fermer la porte ;
d) insérer (F1) le bloc de conditionnement d'air (8) dans l'ouverture de la porte, à partir de sa face extérieure (66), en engageant chaque pion (140) dans un logement (104, 204) d'un des deux supports ;
e) laisser chaque pion glisser, par gravité, vers une position de blocage dans le logement ;
f) ouvrir la porte ; et
g) actionner l'organe mécanique (40) pour verrouiller chaque pion dans sa position de blocage dans son logement.

## Patentansprüche

1. Schaltschrank (2), umfassend ein Gestell (4) und eine Tür (6), die an diesem Gestell angelenkt ist, und ausgestattet mit einem Klimatisierungsblock (8), der in einer Öffnung (62) aufgenommen ist, die durch die Tür ausgebildet ist, **dadurch gekennzeichnete dass** eine Halterung (10, 20) auf jeder Seite der Öffnung an der Innenseite (64) der Tür befestigt ist, dass jede Halterung mit mindestens einem Gehäuse (104, 204) zum Aufnehmen und Arretieren durch Schwerkraft eines Abschnitts (142) eines von der Klimaanlage getragenen Stifts (140) ausgestattet ist, dass jede Halterung konfiguriert ist, damit der Stift durch Schwerkraft in das Aufnahme- und Arretiergehäuse eingreifen kann, indem der Klimaanlagenblock von der Außenseite (66) der Tür in die Öffnung der Tür eingeführt wird, und dass mindestens ein mechanisches Element (40), das an der Innenseite der Tür montiert ist, es ermöglicht, jeden Stift in der arretierten Konfiguration in seinem Gehäuse zu verriegeln.

2. Schaltschrank (2) nach Anspruch 1, **dadurch gekennzeichnet, dass** jedes Gehäuse (104, 204) einen Sitz (1046), der dazu bestimmt ist, einen Stift durch Schwerkraft zu arretieren, und einen Führungsabschnitt (1044) für den Stift in Richtung dieses Sitzes umfasst.

3. Schaltschrank (2) nach einem der vorherigen Ansprüche, **dadurch gekennzeichnet, dass** die Halterung (10, 20) ein Profil mit L-förmigem Querschnitt ist, in dem jedes Gehäuse durch ein Gehäuse (104, 204) gebildet ist, der in den zwei Schenkeln (106, 108, 206, 208) des L ausgebildet wird.

4. Schaltschrank (2) nach den Ansprüchen 2 und 3, **dadurch gekennzeichnet, dass** der Ausschnitt (104, 204) einerseits eine Mündung (1042), die an einem ersten der zwei Schenkel des L (106, 206) ausgebildet ist, und andererseits den Führungsabschnitt (1044) und den Sitz (1046), die an dem zweiten Schenkel des L (108, 208) ausgebildet sind, umfasst, und dass der Führungsabschnitt die Mündung und den Sitz verbindet.

5. Schaltschrank (2) nach einem der vorherigen Ansprüche, **dadurch gekennzeichnet, dass** der Klimatisierungsblock (8) mit einem Rahmen (120) ausgestattet ist, der mit einer Dichtung (132) versehen ist, die an der Außenseite (66) der Tür (6) um die Öffnung (62) anliegt.

6. Schaltschrank (2) nach einem der vorherigen Ansprüche, **dadurch gekennzeichnet, dass** der Klimatisierungsblock (8) vier Stifte (140) trägt, die paarweise auf jeder seiner Seiten verteilt sind, und dass jede Halterung (10, 20) mit zwei Gehäusen (104, 204) zum Aufnehmen und Arretieren eines Abschnitts eines Stifts durch Schwerkraft ausgestattet ist.

7. Schaltschrank (2) nach einem der vorherigen Ansprüche, **dadurch gekennzeichnet, dass** das mechanische Element (40) eine Schraube ist, die in einen Abschnitt (114, 214) einer Halterung (10, 20) eingeschraubt ist und wovon ein Ende an dem Klimatisierungsblock (8) anliegt.

8. Schaltschrank (2) nach einem der Ansprüche 1 bis 6, **dadurch gekennzeichnet, dass** das mechanische Element (40) ein Vorreiberschloss ist.

9. Schaltschrank (2) nach einem der vorherigen Ansprüche, **dadurch gekennzeichnet, dass** jeder Stift (140) mit einem Kopf (144) zur Verriegelung in seinem Gehäuse (104, 204) entlang einer Achse parallel zu der Längsachse des Stifts versehen ist.

10. Verfahren zum Zusammenbauen eines Schaltschranks (2) nach einem der vorherigen Ansprüche, das Verfahren umfassend mindestens die folgenden Schritte:
a) Ausschneiden der Öffnung (62) in der Tür (6);
b) Montieren einer Halterung (10, 20) auf jeder Seite der Öffnung an der Innenseite (64) der Tür;
c) Schließen der Tür;
d) Einsetzen (F1) des Klimaanlagenblocks (8) in die Türöffnung von seiner Außenseite (66) aus, indem jeder Stift (140) in ein Gehäuse (104, 204) einer der zwei Halterungen eingreift;
e) Gleitenlassen von jedem Stift durch Schwerkraft in eine Arretierposition in dem Gehäuse;
f) Öffnen der Tür; und
g) Betätigen des mechanischen Elements (40), um jeden Stift in seiner Arretierposition in seinem Gehäuse zu verriegeln.

## Claims

1. An electrical cabinet (2) comprising a frame (4) and a door (6) articulated on this frame and equipped with an air-conditioning unit (8) received in an opening (62) provided through the door, **characterized in that** a support (10, 20) is fixed on each side of the opening, on the inner face (64) of the door, **in that** each support is equipped with at least one housing (104, 204) for receiving and blocking by gravity a part (142) of a peg (140) carried by the air-conditioning unit, **in that** each support is configured so that the pin can be engaged in the receiving and gravity-locking housing by inserting the air-conditioning unit into the opening of the door, from the outer face (66) of the door, and **in that** at least one mechanical member (40) mounted on the inner face of the door makes it possible to lock each pin in the locked configuration in its housing.

2. An electrical cabinet (2) according to claim 1, **characterised in that** each housing (104, 204) comprises a seat (1046), intended to block a pin by gravity, and a guiding portion (1044) of the pin towards this seat.

3. An electrical cabinet (2) according to one of the preceding claims, **characterised in that** the support (10, 20) is a profile with an L-shaped cross-section in which each housing is formed by a cut-out (104, 204) made in the two branches (106, 108, 206, 208) of the L.

4. Electrical cabinet (2) according to claims 2 and 3, **characterised in that** the cutout (104, 204) comprises, on the one hand, a mouth (1042) formed on a first of the two branches of the L (106, 206) and, on the other hand, the guiding portion (1044) and the seat (1046) formed on the second branch of the L (108, 208) and **in that** the guide part connects the mouth and the seat.

5. Electrical cabinet (2) according to one of the preceding claims, **characterised in that** the air-conditioning unit (8) is equipped with a frame (120) provided with a sealing gasket (132) bearing on the outer face (66) of the door (6) around the opening (62).

6. Electrical cabinet (2) according to one of the preceding claims, **characterised in that** the air-conditioning unit (8) carries four pins (140) distributed in pairs on each of its sides and **in that** each support (10, 20) is equipped with two housings (104, 204) for receiving and blocking by gravity a part of a pin.

7. Electrical cabinet (2) according to one of the preceding claims, **characterised in that** the mechanical member (40) is a screw screwed into a part (114, 214) of a support (10, 20) and one end of which rests on the air-conditioning unit (8).

8. Electrical cabinet (2) according to one of claims 1 to 6, **characterised in that** the mechanical member (40) is a quarter-turn lock.

9. Electrical cabinet (2) according to one of the preceding claims, **characterised in that** each pin (140) is provided with a locking head (144) in its housing (104, 204) along an axis parallel to the longitudinal axis of the pin.

10. A method of assembling an electrical cabinet (2) according to any of the preceding claims, the method comprising at least the steps of:
a) cutting out the opening (62) in the door (6);
b) mounting a bracket (10, 20) on each side of the opening on the inside (64) of the door;
c) closing the door;
d) inserting (F1) the air conditioning unit (8) into the door opening from its outer face (66) by engaging each pin (140) in a recess (104, 204) of one of the two holders;
e) allowing each pin to slide, by gravity, to a locked position in the housing;
f) opening the door; and
g) actuating the mechanical member (40) to lock each pin in its locking position in its housing.
